(19) **Europäisches Patentamt / European Patent Office / Office européen des brevets**

(11) **EP 2 130 211 B1**

(12) **EUROPÄISCHE PATENTSCHRIFT**

(45) Veröffentlichungstag und Bekanntmachung des Hinweises auf die Patenterteilung:
**17.08.2011 Patentblatt 2011/33**

(51) Int Cl.:
**H01J 1/304** $^{(2006.01)}$

(21) Anmeldenummer: **08716002.4**

(86) Internationale Anmeldenummer:
**PCT/EP2008/001454**

(22) Anmeldetag: **23.02.2008**

(87) Internationale Veröffentlichungsnummer:
**WO 2008/107084 (12.09.2008 Gazette 2008/37)**

(54) **FELDEMISSIONSQUELLE FÜR ELEKTRONEN ALS FELDEMISSIONSKATHODE**

FIELD EMISSION SOURCE FOR ELECTRONS AS A FIELD EMISSION CATHODE

SOURCE D'ÉMISSION DE CHAMP D'ÉLECTRONS CONÇUE EN TANT QUE CATHODE D'ÉMISSION DE CHAMP

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **02.03.2007 DE 102007010297**

(43) Veröffentlichungstag der Anmeldung:
**09.12.2009 Patentblatt 2009/50**

(73) Patentinhaber: **GSI Helmholtzzentrum für Schwerionenforschung GmbH
64291 Darmstadt (DE)**

(72) Erfinder:
- **TRAUTMANN, Christina
  64291 Darmstadt (DE)**
- **BLAUM, Klaus
  55595 Bockenau (DE)**
- **QUINT, Wolfgang
  64839 Münster (DE)**
- **SCHABINGER, Birgit
  55122 Mainz (DE)**
- **ALONSO, Joseba
  55118 Mainz (DE)**
- **ULMER, Stefan
  55128 Mainz (DE)**
- **MAURER, Florian
  64347 Griesheim (DE)**
- **BRÖTZ, Joachim
  65553 Limburg (DE)**

(56) Entgegenhaltungen:
**US-A1- 2002 158 342     US-A1- 2003 143 398**

- **VILA ET AL.: "Growth and Field-Emission Properties of Vertically Aligned Cobalt Nanowire Arrays" NANO LETTERS, Bd. 4, Nr. 3, 17. Februar 2004 (2004-02-17), XP009102016**
- **TOIMIL MOLARES M E ET AL: "Etched heavy ion tracks in polycarbonate as template for copper nanowires" NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, Bd. 185, Nr. 1-4, 1. Dezember 2001 (2001-12-01), Seiten 192-197, XP004326834 ISSN: 0168-583X**
- **DMITRI ROUTKEVITCH ET AL: "Nonlithographic Nano-Wire Arrays: Fabrication, Physics, and Device Applications" IEEE TRANSACTIONS ON ELECTRON DEVICES, IEEE SERVICE CENTER, PISCATAWAY, NJ, US, Bd. 43, Nr. 10, 1. Oktober 1996 (1996-10-01), XP011015942 ISSN: 0018-9383**
- **DUBOIS S ET AL: "EVIDENCE FOR A SHORT DIFFUSION LENGTH IN PERMALLOY FROM THE GIANT MAGNETORESISTANCE OF MULTILAYERED NANOWIRES" PHYSICAL REVIEW, B. CONDENSED MATTER, AMERICAN INSTITUTE OF PHYSICS. NEW YORK, US, Bd. 60, Nr. 1, PART 01, 1. Juli 1999 (1999-07-01), Seiten 477-484, XP000832305 ISSN: 0163-1829**
- **L. PIRAUX ET AL.: "Fabrication and properties of organic and metal nanocylinders in nanoporous membranes" JOURNAL OF MATERIALS RESEARCH, Bd. 14, Nr. 7, Juli 1999 (1999-07), Seiten 3042-3050, XP009102034**

EP 2 130 211 B1

- PIRAUX L ET AL: "Template synthesis of nanoscale materials using the membrane porosity" NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, Bd. 131, Nr. 1-4, 1. August 1997 (1997-08-01), Seiten 357-363, XP004100542 ISSN: 0168-583X
- DAUGINET-DE PRA L ET AL: "Fabrication of a new generation of track-etched templates and their use for the synthesis of metallic and organic nanostructures" NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, Bd. 196, Nr. 1-2, 1. November 2002 (2002-11-01), Seiten 81-88, XP004391363 ISSN: 0168-583X
- ENSINGER ET AL: "Diameter distributions of metallic nanowires formed by galvanic deposition inside polymer matrix pores" MATERIALS SCIENCE AND ENGINEERING C, ELSEVIER SCIENCE S.A, CH, Bd. 25, Nr. 5-8, 1. Dezember 2005 (2005-12-01), Seiten 609-613, XP005161138 ISSN: 0928-4931
- LIU J ET AL: "Electrochemical fabrication of single-crystalline and polycrystalline Au nanowires: the influence of deposition parameters; Electrochemical fabrication of single-crystalline and polycrystalline Au nanowires: the influence of deposition parameters" NANOTECHNOLOGY, IOP, BRISTOL, GB, Bd. 17, Nr. 8, 28. April 2006 (2006-04-28), Seiten 1922-1926, XP020104660 ISSN: 0957-4484

**Beschreibung**

Die Erfindung betrifft eine Feldemissionsquelle für Elektronen als Feldemissionskathode. Die Feldemission erfolgt aus den frei stehenden Spitzen von elektrisch leitenden Nanodrähten, die auf einem elektrisch leitenden Substrat stehen. Die Nanodrähte wurden in einem elektrochemischen Herstellungsprozess in einer Polymer-Ionenspur-Membran gezogen, bzw. sind darin gewachsen.

Die üblicherweise verwendeten Elektronenquellen bestehen aus einer einzelnen Feldemissionsspitze - meist aus Wolfram - oder Rastertunnelmikroskop-Spitze. Im Falle eines Versagens dieser einzelnen Spitze muss diese Elektronenquelle unter erheblich technischem und zeitlichem Aufwand ausgetauscht werden, weil die Einsatztemperatur und das Einsatzvakuum dazu aufgegeben werden muss.

Feldemitter mit kleinem Krümmungsradius, also Spitzen, können aus einer Vielzahl von Materialien hergestellt werden. Viel versprechende Experimente und erste Anwendungen wurden bereits mit Ensembles aus Kohlenstoff-Nanoröhren, KNR, erzielt. Dabei wird unter Ensemble eine stochastisch verteilte Emitteranordnung verstanden, im Gegensatz zu einem Array, das aus regelmäßig, hexagonal oder kubisch, angeordneten Emittern besteht. Konische, metallische Feldemitteranordnungen, Arrays, sind kommerziell von der Spindt Company erhältlich. Die Niedrigleistung und Leichtgewichtigkeit von Spindt-Kathoden sind ideal für Raumfahrtanwendungen, die Elektronenemission verlangen, geeignet, weil die Robustheit und Wirksamkeit der Baugruppen die Fähigkeit bereitstellt, Ströme von nA bis in den Zehn-mA-Bereich pro Spitze zu emittieren. Gruppiert in Anordnungen von einer Einzelspitze bis zu Millionen an Spitzen pro Quadratzentimeter, stellen Spindt-Kathoden einen Mechanismus zum Emittieren gesteuerter Ströme gut über die 1 A-Schranke von einem Kleinleistungs-, Kaltkathoden-Baugruppe, die nur durch thermische und Raumladungseffekte beschränkt ist. Arrays von orientierten KNRn werden in Flachbildschirmen eingesetzt. Diese so genannten Spindt-Kathoden sind verhältnismäßig teuer und erfordern in der Herstellung aufwendige mehrstufige Prozessschritte.

In Nucl. Instr. And Meth.in Phys. Research B 245 (2006) 337 - 341 stellen F. Maurer et al. eine Abhandlung über „Field emission of copper nanowires grown in polymer ion.track membranes" vor. Integrale und lokale Feldemissionsuntersuchungen wurden mit Ensembels unterschiedlich geometrischer Beschaffenheit durchgeführt, die Dichten der Emissionsorte bis zu $1,4*10^5$ cm$^{-2}$ bei 6 V/µm erreichten. Nur 6% der frei stehenden und vertikal ausgerichteten Nanodrähte waren starke Emitter. Nahezu alle Drähte zeigen instabiles Fowler-Nordheim-Verhalten, unterschiedliche β-Werte für ansteigende und absteigende Spannungszyklen, mit einem mittleren β-Wert von 245. Das ist um einen Faktor drei höher als von der Emitterform erwartet, möglicherweise wegen des Einflusses der Spitzengeometrie. Für Nanodrähte von 18 µm Länge und Submikronabstand, agglomerierten mehrere hundert Nanodrähte zu Bündeln, die ebenfalls Feldemission zeigten.

Der Erfindung liegt die Aufgabe zugrunde, eine Feldemissionskathode als Elektronenquelle bereit zu stellen, die es ermöglicht unter bestimmten extremen Temperatur- und Druckbedingungen reproduzierbar Elektronenströme bis zu einigen Mikroampere zu erzeugen, dabei soll beim Versagen einer Emissionsspitze der Emissionsstrom nicht zusammenbrechen. Die Apparatur, in der eine solche Feldemissionskathode eingebaut ist soll langzeitlich ein stabiles Betriebsverhalten aufweisen.

Die Aufgabe wird durch eine Feldemissionskathode als Feldemissionsquelle für Elektronen gemäß den kennzeichnenden Merkmalen des Anspruchs 1 gelöst nämlich, dass die Feldemissionskathode zumindest in ihrem exponierten Bereich mit einem korrosionsbeständigen Material überzogen ist, welches ein Edelmetall aufweist. Die Feldemissionskathode ist in einer Elektronenstrahlanlage als Ersatz von Kathodenstrahlröhren und Displays beispielsweise eingebaut und bildet im Betrieb eine nichtthermische, nur über elektrische Potentialunterschiede zwischen der Feldemissionskathode und der Anode der Anlage/Apparatur gesteuerte, stabile Elektronenquelle für Ströme im Bereich vom unteren nA- bis in den µA-Bereich, kurz unter dem Begriff Feldemission gefasst.

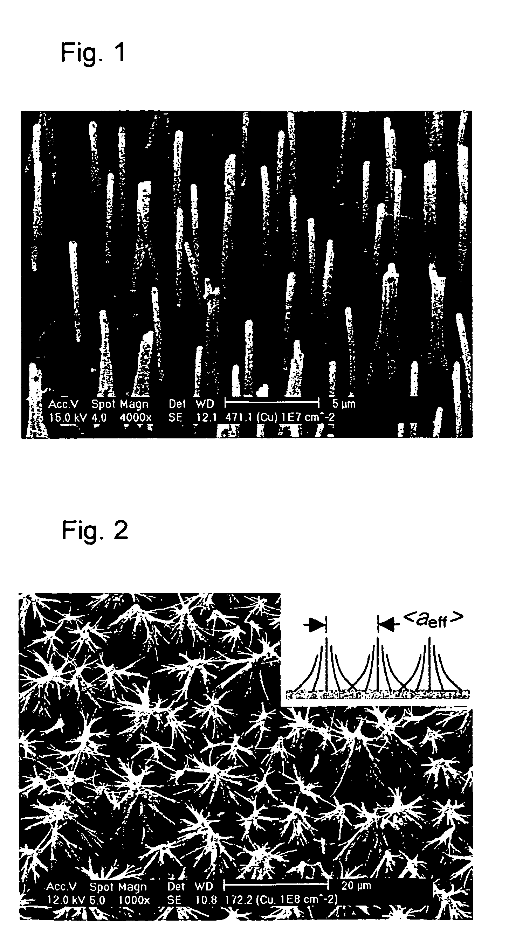

Durch die hohe Feldemission, gegeben insbesondere durch die Geometrie der Spitzen der Nanodrähte, spielt die thermische Emission keine Rolle, was besonders günstig für den Betrieb bei tiefen Temperaturen ist. Im Gegensatz zu reinen Einspitzen-Feldemissionskathoden ist die Feldemissionskathode hier ein Ensemble stochastisch verteilter Feldemissionsstrukturen/ Spitzen aus frei stehenden, vorzugsweise senkrecht stehenden Nanodrähten aus elektrochemisch abscheidbaren, metallischen Materialien. Die Nanodrähte stehen nach Auflösung der Polymerschicht durch ein geeignetes Lösungsmittel (siehe oben stehendes Literaturzitat aus Nucl. Instr. And Meth. von F. Maurer et al.) frei exponiert. Bei hinreichender Länge der Nanodrähte, siehe unten, bilden sich Nanodrahtbündel, die jeweils durch Anlehnen/Zuneigen von Nanodrähten aus der Umgebung eines Nanodrahtes an diesen entstehen (siehe schematisierten Ausschnitt der Bündelbildung in Fig 2). Die Bündel beginnen sich bei einem Aspektverhältnis: Nanodrahthöhe h : Nanodrahtdurchmesser d größer als ca. 50 auszubilden. Die Bündelung erfolgt vorwiegend beim Auflösen der Polymerschablone durch Strömung/ Bewegung im Lösungsmittel. Diese Bündelung, Aggregation, Agglomeration von Gruppen von Nanodrähten ist bei der Herstellung der Feldemissionsstrukturen ein qualitativ selbsttätiger Vorgang und kann durch die Nanodrahtgeometrie und Nanodrahtdichte in der Ausgestaltung gesteuert werden. Die Nanodrahtbündelung ist im Mittel symmetrisch und beim Bündelabstand wird von einem mittleren effektiven Abstand gesprochen, wozu der mittlere Abstand $<a_{eff}>$ zweier Bündelspitzen herangezogen wird (siehe auch Figur 2). Ein solches Bündel ist mechanisch durch die Stützwirkung der anlehnenden Nanodrähte stabil und weist für die Emission zentral die freie, notwendige Spitze eines einzelnen Nanodrahtes auf, wodurch die vorteilhafte Emissionseigenschaft eines einzelnen Nanodrahtes besteht.

Die Feldemissionsstrukturen der Feldemissionskathode stehen im Bereich von $10^3$ bis $10^9$ Nanodrähten/cm$^2$ ungeordnet, stochastisch verteilt, dicht. Die einzelne Emissionsstruktur hat zu den benachbarten Emissionsstrukturen einen mittleren Abstand $<a>$ im Bereich von 0,1 bis 50 $\mu$m. Der Durchmesser d der Nanodrähte liegt im Bereich von 10 nm bis 10 $\mu$m, und die Höhe h der Nanodrähte liegt im Bereich von 1 bis 100 $\mu$. In diesen geometrischen Bereichen liegen dann Nanodrahtstrukturen vor, die mechanisch stabil gehalten werden können und jeweils eine frei Spitze für die einwandfreie Steuerung der Elektronenemission aufweisen. Eine solche Feldemissionskathode emittiert je nach elektrischer Potentialeinstellung zwischen Feldemissionskathode und Anode aus der Spitze mindestens einer Emissionsstruktur. Durch Wahl der Potentialdifferenz ist die Zahl emittierender Nanodrahtspitzen bei frei stehenden Nanodrähten mit höher werdender Nanodrahtdichte im Wesentlichen im Mittel und nicht in der exakten Anzahl einstellbar; bei Nanodrahtbündeln entsprechend der Nanodrahtbündeldichte. D.h. das Emissionsgebiet der Feldemissionskathode ist nicht notwendigerweise ortsfest. Bei gleichmäßiger Nanodrahtausbildung lässt sich zumindest für einen zentralen Flächenbereich der Feldemissionskathode eine homogene Elektronenemission einstellen, die durch die einstellbare Potentialdifferenz in Grenzen steuerbar ist. (Der unvermeidliche Materialabtrag an den Nanodrahtspitzen wird unten erörtert.) Beim Ausfall einer Feldemissionsstruktur übernimmt eine andere Feldemissionsstruktur oder übernehmen die andern Feldemissionsstrukturen die Elektronenemission. Es besteht somit eine Art Redundanz an Emittern, so dass die Elektronenemission in einem solchen Ausfall unterbrechungslos fortgeführt wird. Durch eine solche Struktur der Feldemissionskathode ist eine um ein Vielfaches höhere Betriebs- und Langzeitstabilität gegeben. Eine Anlage/Apparatur, die eine Feldemissionskathode aus einem solchen Ensemble aus Feldemissionsstrukturen eingebaut hat, muss spätestens dann erst geöffnet werden, wenn auch bei kleinen Emissionsströmen (und damit kleine Potentialdifferenzen) kein steuerbarer Elektronenstrom mehr zustande kommt. Das Ausfallrisiko eines solchen Ensembles ist um ein Vielfaches geringer, die Betriebsdauer also um ein Vielfaches länger als bei einer Einzelemissionsspitze, wie bei den herkömmlichen Wolframspitzen beispielsweise.

Zur unproblematischen Handhabung beim Ein- und Ausbau ist die Feldemissionskathode nach Anspruch 2 zumindest in ihren exponierten Bereichen mit einem korrosionsbeständigen Metall, welches ein Edelmetall aufweist, überzogen. Im Falle von Edelmetall bedeutet das auch eine leichtere Elektronenemission aus dem Spitzenbereich der Nanodrähte. In den Unteransprüche 2 bis 4 werden geeignete Materialeigenschaften einer solchen Feldemissionskathode beschrieben

Für den Betrieb der Feldemissionskathode in einer Umgebung mit Magnetfeld wird das Material für die Nanodrähte so gewählt, dass der Elektronenstrom im Magnetfeld nicht beeinträchtigt wird. Das wird in Anspruch 2 durch die Aufführung der magnetischen Materialeigenschaft: magnetisch oder nicht, hervorgehoben.

Um den Materialabtrag insbesondere an der Spitze eines emittierenden Nanodrahtes zu unterbinden oder wenigstens in Grenzen zu halten, ist es von Fall zu Fall zweckmäßig, den Nanodraht aus verschiedenen, für den Betrieb geeigneten Materialien elektrochemisch aufzubauen (Anspruch 3, das durch Nacheinanderanwenden entsprechender Elektrolyte einfach erreichbar ist. Die Nanodraktspitze kann so mindestens mit ihrem Emissionsgebiet aus einem harten Metall, Wolfram beispielsweise, bestehen. Auch ist eine mechanische Steifigkeit des Nanodrahtes mit durch Materialwahl einstellbar. Desgleichen besteht nach Anspruch 5 das Substrat der Nanodrähte aus mindestens einer Metallschicht, was für den elektrischen Übergang vom Substrat und deren mechanischer Verankerung von Bedeutung ist (Anspruch 4), d. h. als mechanischer Träger kann ein elektrisch leitfähiger aber preisgünstigerer Träger wie ein Edelmetall herangezogen werden.

Gegenüber den herkömmlichen Feldemissionskathoden, wie Spind-Kathoden (regelmäßig aufgebaute Feldemissionskathode), Wolfram-Kathoden (Einzelemissionskathode), LaB$_6$-Kathoden, ergeben sich herausragende Vorteile:

- in der Material-/Metallwahl für die Nanodrähte besteht im Rahmen elektrochemisch abscheidbarer Materialien Flexibilität und damit ein einfacher Herstellungsprozess;
- Anpassung an Anforderungen physikalischer Art, wie magnetische Materialeigenschaft, oder chemischer Art, wie Korrosionsresistenz, ist gegeben;
- in der Einstellung der Nanodrahtgeometrie besteht hinsichtlich des mittleren Nanodrahtabstand $<a>$, des Nanodrahtdurchmessers d und der Nanodrahtlänge h wegen des Herstellungsprozesses Freiheit;
- die Elektronenemission aus den Spitzen der Feldemissionskathode erfolgt über elektrische Potentialeinstellung zwischen Kathode und Anode und nicht oder allenfalls untergeordnet durch thermische Emission. Somit liegt mit der Feldemissionskathode eine stabile Elektronenquelle vor und unter kryogenen Bedingungen zusätzlich eine kalte Elektronenquelle;
- es ist mit der Feldemissionskathode eine Elektronenemission mit äußerst geringen elektrischen Strömen in den zuführenden Leitungen gegeben, nA- bis $\mu$A-Breich (thermische Kathoden emittieren im A-Bereich); der Einsatz in starken Magnetfeldern im Tesla-Bereich wird durch auftretende magnetische Lorentz-Kräfte nicht behindert;

- aufgrund zahlreicher Elektronemitter besteht insbesondere eine Redundanz durch die große Spitzenanzahl der Emissionszentren, die im Falle des Versagens eines Emitters die Emission übernehmen/fortführen;

- es besteht ein geringes Ausfallrisiko der Anlage/Appartur, die mit einer Feldemissionskathode mit einem solchen Emitterensemble bestückt ist im Gegensatz zu einer einzigen Emissionsspitze wie beispielsweise einer Wolframspitze;

- es ist die Elektronenemission aus einer bis zu vielen Nanodrahtspitzen einstellbar, insbesondere kann über Potentialsteuerung auch eine flächig homogene Emission aus der Feldemissionskathode eingestellt werden.

Im Folgenden wird die Feldemissionskathode in zwei baulichen Varianten vorgestellt und anschließend die Leistungsfähigkeit der Feldemissionskathode in Form eines Ensembles stochatisch, ungeordnet verteilter Nanodrähte vorgestellt. Hierzu werden die folgenden Figuren herangezogen:

Figur 1 Ensemble-Ausschnitt aus frei stehenden Nanodrähten aus Kupfer;
Figur 2 Nanodrähte zu sternförmigen Bündeln agglomeriert;
Figur 3 I-U-Kurven;
Figur 4 von der magnetischen Feldstärke unabhängiger Emissionsstrom;
Figur 5 Langzeitstabilität des Emissionsstroms.

Figur 1 den mit einem Rasterelektronenmikroskop aufgenommen Bildausschnitt der Feldemissionskathode aus frei stehenden Nanodrähten aus Kupfer auf einem Gold/Kupfer-Substrat mit einem mittleren Nanodrahtabstand $\langle a \rangle \sim 1~\mu m$, mit einer Nanodrahtdichte N $\approx 10^7~cm^{-2}$.

Die Leistungsfähigkeit der Feldemissionskathode, die aus einem Ensemble ungeordnet, stochastisch verteilter Feldemissionsstrukturen/Spitzen aus frei stehenden, vorteilhafterweise senkrecht stehenden Nanodrähten aus elektrochemisch abscheidbaren, metallischen Materialien oder daraus gebildeten Nanodrahtbündeln, wie oben erläutert, wird im Folgenden vorgestellt. Zur Erläuterung wird die Fowler-Nordheim-Theorie herangezogen, die einen Zusammenhang zwischen dem angelegten elektrischen Feld und der Stromstärke der Feldemission gibt. Die Stromdichte j der Feldemission berechnet sich in Abhängigkeit des elektrischen Feldes E, des Feldüberhöhungsfaktor β und der Austrittsarbeit φ des Materials in einer ersten Nährung zu

$$ j = \frac{A(\beta E)^2}{\phi} \exp\left( -\frac{B\phi^{\frac{3}{2}}}{\beta E} \right) $$

A und B sind Konstanten.

Die Ergebnisse des Cu-Nanodrahtemsembles als kryogene Elektronenquelle zeigen hervorragende Feldemissionseigenschaften. Die Anforderungen an die Stromstärke der kryogenen Elektronequelle liegt für die Produktion geladener Teilchen, d.h. Ionen, in einer kryogepumpten UHV-Kammer nach dem Electron Beam Ion Source-Prinzip, EBIS, typischerweise im Bereich von einigen nA. Diese Stromstärke wurde von dem Ensemble bei Anwesenheit einer Adsorbatschicht um ein vielfaches übertroffen.

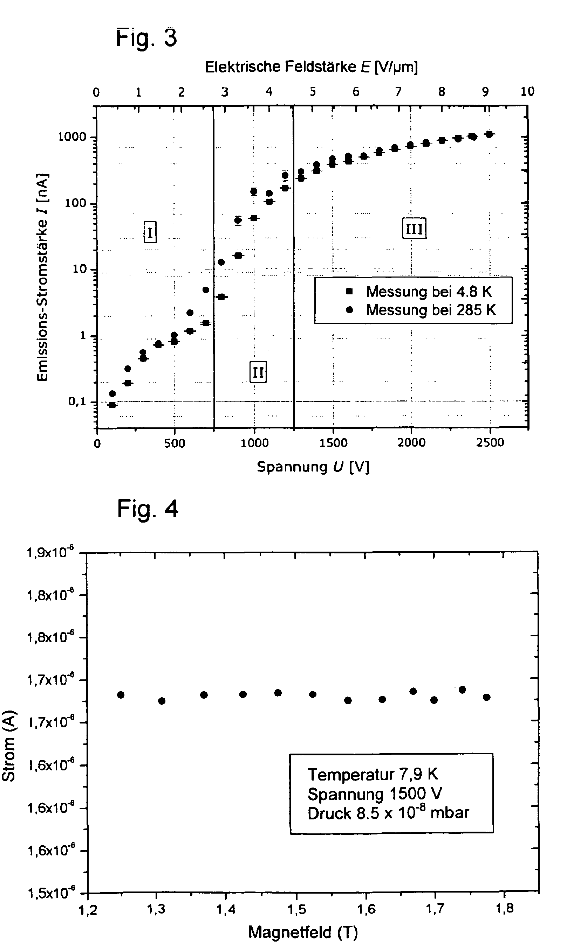

Die in Figur 3 gezeigten Daten wurden integral gemessen, d.h. ein externes elektrischres Feld wurde an ein Nanodrahtensemble mit einer Fläche von etwa 0,15 cm$^2$ bei einer Flächendichte von $10^6$ Emitter/cm2 angelegt. Der Verlauf der Stromstärke im Bereich I ist auf Leckströme zurückzuführen. Die Einsatzfeldstärke $E_0$ der Feldemission für einen Emissionsstrom von ca. 2 nA liegt bei etwa 2,5 V/μm. Dieser Wert stellt einen für Anwendungen günstigen Wert dar, da man die benötigten Ströme bereits bei geringen externen Spannungen erzeugt. Das Risiko von Spannungsüberschlägen wird dadurch vermieden, wodurch die äußerst sensible Elektronik der Nachweissysteme geschützt wird. Typische Werte für $E_0$ liegen zwischen 3 und 5 V/μm. Bereich II folgt der Theorie nach obiger Gleichung. Im Bereich III ist der Strom limitiert aufgrund von Adsorbaten und/oder Raumladungen. Aus Bereich II wird der Feldüberhöhungsfaktor β zu einem Wert von etwa 2 000 bestimmt, d.h. das extern angelegte elektrische Feld wird an den Spitzen eines Nanodrahtes oder mehrerer Nanodrähte um das 2 000-fache erhöht. Dadurch wird die Feldemission an diesen Emittern um ein Vielfaches begünstigt und es resultiert eine niedrige Einsatzfeldstärke $E_0$.

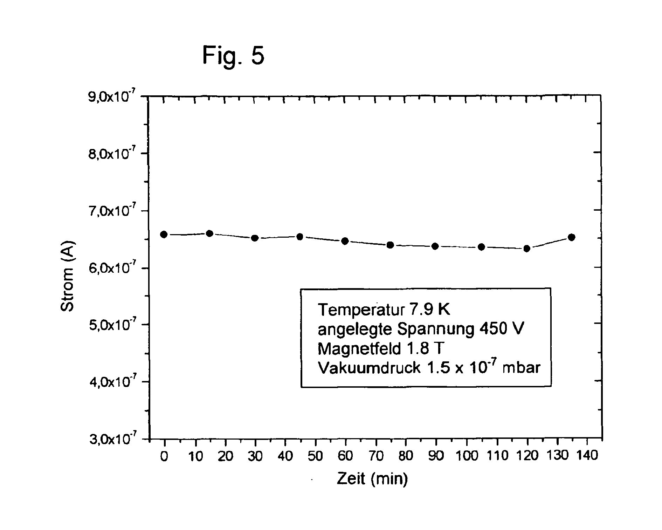

Für kernphysikalische Experimente und Hochpräzisionstests der Quantenelektrodynamik werden häufig extreme Arbeitsbedingungen benötigt. Ein Beispiel stellt hierbei die Präzisionsmessung des g-Faktors eines einzelnen, in einer Penning-Falle gespeicherten Teilchens dar. Um die Nachweiseffizienz zu erhöhen, werden diese Experimente bei kryogenen Temperaturen, T ~ 4 K, durchgeführt. Hierbei werden, bedingt durch den Kryopumpeffekt, Vakuumdrücke in der Größenordnung von $10^{-16}$ mbar erreicht. Das Cu-Nanodrahtensemble wird unter diesen extremen Bedingungen zur Erzeugung eines Elektronenstrahls genutzt, der auf ein geeignetes Target gelenkt wird. So werden die zu spektroskopierenden, geladenen Teilchen erzeugt. Das Nanodrahtensemble zeigte hierbei eine Unabhängigkeit seiner Emissionsstromstärke bei variablen, starken Magnetfeldern B (Figur 4) und zeitliche Stabilität des Emissionsstroms (Figur 5). Die hohe Zuverlässigkeit, bedingt durch die hohe Emitterdichte der Nanodrahtensembles, ist von entscheidender Bedeutung für zügiges Experimentieren. Die Verwendung einzelner Feldemissionsspitzen wie zum Beispiel Wolframkathoden stellt ein erhebliches Ausfallrisiko dar. Bei Beschädigung dieser müssen die komplexen Apparaturen teilweise demontiert und wieder aufgebaut werden, und das geht unvermeidlich mit einem erheblichen Zeit- und Kostenfaktor einher.

Figur 2 zeigt den mit einem Rasterelektronenmikroskop aufgenommenen Ausschnitt der Feldemissionszentren aus agglomerierten Nanodrähten. Die physikalischen und geometrischen Daten sind im Bild unten eingeblendet. Jede Spitze eines Bündels kann dabei theoretisch als Emissionszentrum auftreten. Eingeblendet in das Bild ist der schematische Aufbau zweier benachbarter Bündel, deren beide spitzebildende Nanodrähte die Schnittebene bilden und darin den mittleren effektiven Abstand $<a_{eff}>$ zueinander haben. Diese Geometrie aus agglomerierten Nanodrähten hat gegenüber einzelnen, vertikal frei stehenden Nanodrähten folgende Vorteile:

- höhere Standfestigkeit, höhere mechanische Stabilität:

  dadurch können Nanodrähte mit höheren Aspektverhältnissen wegen gegenseitigem Abstützen verwendet werden;

- Selbstordnung der Bündel:

  dadurch erhöht sich der mittlere Abstand der Emissionszentren und erreicht etwa deren Höhe, $<a> \sim h$, weiter werden dadurch elektrostatische Abschirmeffekte reduziert und die Feldemission verbessert;

- die Verteilung des mittleren Abstandes $<a>$ ist enger als bei vertikal frei stehenden Einzeldrähten;
- damit einher geht eine höhere Symmetrie der Anordnungen; durch die Agglomeration mehrerer Nanodrähte zu Bündeln können höhere Emissionsströme transportiert werden.

**Patentansprüche**

1. Feldemissionskathode als Feldemissionsquelle für Elektronen, wobei im Betrieb die Elektronenemission aus den freien spitzen von elektrisch leitenden Nanodrähten, die auf einem elektrisch leitenden Substrat stehen, über die einstellbare elektrische Potentialdifferenz zwischen der Feldemissionskathode und einer Anode erfolgt, wobei die Feldemissionskathode als stabile Elektronenquelle für Ströme im Bereich vom unteren nA- bis in den µA-Bereich ausgebildet ist,

die Emission durch elektrische Potentialunterschiede zwischen der Feldemissionsquelle und einer Anode steuerbar ist, wobei die Emission durch thermische Energie zumindest vernachlässigbar ist, die Feldemissionskathode ein Ensemble stochastisch verteilter Feldemissionsstrukturen aus Nanodrahtbündeln ist, die aus frei steherrden Nanodrähten aus elektrochemisch abscheidbaren, metallischen Materialien gebildet sind und die auf dem substrat stehen, wobei:

die Feldemissionsstrukturen der Feldemissionskathode mit $10^3$ bis $10^9$ cm$^{-2}$ dicht stehen, die einzelne Emissionsstruktur zu den benachbarten Emissionsstrukturen einen mittleren Abstand $<a>$ im Bereich von 0,1 bis 50 µm hat, der Durchmesser d der Nanodrähte im Bereich von 10 nm bis 10 µm und die Höhe h der Nanodrähte im Bereich von 1 µm bis 100 µm liegen, die Feldemissionskathode derart ausgebildet und eingerichtet ist, dass sie über die Fläche des Ensembles aus Feldemissionsstrukturen bei entsprechend eingestellter Potential differenz aus der Spitze mindestens einer Feldemissionsstruktur Elektronen emittiert und eine Mehrzahl an Feldemissionsstrukturen vorhanden ist, derart, dass beim Ausfall einer Feldemissionsstruktur selbsttätig eine andere Feldemissionsstruktur die Emission übernimmt oder selbsttätig andere Feldemissionsstrukturen die Emission übernehmen, **dadurch gekennzeichnet, dass** die Feldemissionskathode zumindest in ihrem exponierten Bereich mit einem korrosionsbeständigen Material überzogen ist, welches ein Edelmetall aufweist.

2. Feldemissionskathode nach Anspruch 1 , **dadurch gekennzeichnet, dass** zumindest die Nanodrähte aus magnetischem oder nichtmagnetischem Material sind.

3. Feldemissionskathode nach einem der vorangehenden Ansprüche, **dadurch gekennzeichnet, dass** die Nanodrähte in ihrem Kern und ihrer Länge aus einer Materialart oder wenigstens zwei verschiedenen Materialarten bestehen.

4. Feldemmissionskathode nach einem der vorangehenden Ansprüche, **dadurch gekennzeichnet, dass** das Substrat der Feldemissionskathode, auf dem die Feldemitter stehen, metallisch oder halbleitend, ein- oder mehrschichtig ist.

5. Verfahren zur Ausbildung einer Feldemissionskathode als Feldemissionsquelle für Elektronen nach einem der Ansprüche 1 bis 5, bei der die Elektronenemission aus den freien Spitzen von elektrisch leitenden Nanodrähten, über die einstellbare elektrische Potentialdifferenz zwischen der Feldemissionskathode und einer Anode erfolgt, wobei die leitenden Nanodrähte in einem ersten Schritt auf einem elektrisch leitenden Substrat stehen und in einer Polymer-Ionenspur-Membran gewachsen werden, **dadurch gekennzeichnet, dass**:

die dabei entstehenden einzelne, freistehenden Nanodrähte in einem zweiten Schritt durch Strömung/Bewegung im Lösungsmittel beim Auflösen der Polymer - Ionenspur - Membran durch Anlehnen/Zuneigen von Nanodrähte aus der Umgebung das Ensemble stochastisch verteilter Feldemissionsstrukturen aus Nanodrahtbündeln ausbilden,

und dass die Feldemissionskathode zumindest in ihrem exponierten Bereich mit einem korrosionsbeständigem Materialüberzogen wird, welches ein Edelmetall aufweist.

## Claims

1. Field emission cathode as a field emission source for electrons, wherein during operation the electron emission is generated from the free tips of electrically-conducting nanowires that stand on an electrically-conducting substrate by the adjustable electrical potential difference between the field emission cathode and an anode,

wherein the field emission cathode is formed as a stable electron source for currents in the range of low nA to the $\mu$A range,

the emission through electrical potential differences between the field emission source and an anode is controllable, wherein the emission through thermal energy is at least negligible,

the field emission cathode is an ensemble of stochastically-distributed field emission structures of nanowire bundles, that comprise free-standing nanowires of electrochemically-depositable metallic materials that stand on the substrate,

wherein:

the field emission structures of the field emission cathode have a density of $10^3$ - $10^9$ cm$^{-2}$,

the mean distance <a> between an individual emission structure and its neighbouring emission structures is in the range 0.1 to 50 $\mu$m,

the diameter d of the nanowires is in the range 10 nm to 10 um and

the height h of the nanowires is in the range 1 $\mu$m to 100 $\mu$m,

the field emission cathode is formed and arranged such that it emits electrons from the tip of at least one field emission structure over the area of the ensemble of field emission structures when the potential difference is correspondingly set,

and a plurality of field emission structures is present such that if one field emission structure fails then another field emission structure or other field emission structures will automatically take over the emission,

**characterized in that**

the field emission cathode is covered at least in its exposed region with a corrosion-resistant material, which incorporates a noble metal.

2. Field emission cathode according to claim 1, **characterized in that** at least the nanowires are of magnetic or non-magnetic material.

3. Field emission cathode according to one of the above claims, **characterized in that** the nanowires comprise one type of material or at least two different types of material in their core and their length.

4. Field emission cathode according to one of the above claims, **characterized in that** the substrate of the field emission cathode, on which the field emitters stand, is metallic or semi-conducting, and has one or more layers.

5. Method for the formation of a field emission cathode as field emission source for electrons according to one of claims 1 to 5, wherein the electron emissions from the free tips of electrically-conducting nanowires are generated by an adjustable electrical potential difference between the field emission cathode and an anode,

wherein the conducting nanowires in a first step stand on an electrically-conducting substrate and are grown in a polymer ion trace membrane, **characterized in that**:

in a second step the resultant individual freestanding nanowires form the ensemble of stochastically distributed field emission structures from nanowire bundles through flow/movement in solvent upon dissolution of the polymer ion trace membrane by inclination/attraction of nanowires from the surrounding area,

and that the field emission cathode at least in its exposed region is covered by a corrosion-resistant material that incorporates a noble metal.

## Revendications

1. Cathode d'émission de champ conçue en tant que source d'émission de champ pour électrons, sachant qu'en service, l'émission d'électrons depuis les pointes libres de nanofils électroconducteurs se dressant sur un substrat électroconducteur est assurée par la différence de potentiel électrique réglable entre la cathode d'émission de champ et une anode,

que la cathode d'émission de champ est conçue comme source d'électrons stable pour des courants dans la plage allant des nA inférieurs jusqu'aux µA,

que l'émission par des différences de potentiel électriques entre la source d'émission de champ et une anode est contrôlable, l'émission par énergie thermique pouvant au moins être négligée,

que la cathode d'émission de champ est un ensemble de structures d'émission de champ réparties de manière stochastique et constituées de faisceaux de nanofils formés par des nanofils isolés réalisés en matériaux métalliques pouvant être déposés par un procédé électrochimique et qui se dressent sur le substrat,

les structures d'émission de champ de la cathode d'émission de champ étant disposées selon une concentration comprise entre $10^3$ et $10^9$ cm$^{-2}$,

que la distance moyenne <a> entre deux structures émettrices voisines est comprise entre 0,1 et 50 µm,

que le diamètre d des nanofils est compris entre 10 nm et 10 µm

et

que la hauteur h des nanofils est comprise entre 1 µm et 100 µm,

que la cathode d'émission de champ est conçue et ajustée de manière telle que sur la surface de l'ensemble constitué de structures d'émission de champ, elle émette des électrons depuis une pointe d'au moins une structure d'émission de champ si la différence de potentiel est réglée en conséquence et qu'il existe une pluralité de structures d'émission de champ telle qu'en cas de défaillance d'une structure d'émission de champ, une autre structure d'émission de champ ou d'autres structures d'émission de champ reprennent automatiquement l'émission,

**caractérisée en ce que**

qu'au moins dans sa zone exposée, la cathode d'émission de champ est recouverte d'un matériau résistant à la corrosion et présentant un métal précieux.

2. Cathode d'émission de champ selon la revendication 1, **caractérisée en ce qu'**au moins les nanofils sont réalisés en un matériau magnétique ou non magnétique.

3. Cathode d'émission de champ selon l'une des revendications précédentes, **caractérisée en ce que** dans leur âme et leur longueur, les nanofils sont constitués d'un type de matériau ou d'au moins deux types de matériaux différents.

4. Cathode d'émission de champ selon l'une des revendications précédentes, **caractérisée en ce que** le substrat de la cathode d'émission de champ, sur lequel sont placés les émetteurs de champ, est métallique ou semi-conducteur, monocouche ou multicouche.

5. Procédé destiné à former une cathode d'émission de champ en tant que source d'émission de champ pour électrons selon l'une des revendications 1 à 5, dans lequel l'émission d'électrons depuis les pointes libres de nanofils électroconducteurs est assurée par la différence de potentiel électrique réglable entre la cathode d'émission de champ et une anode, sachant que dans une première étape, les nanofils conducteurs se dressent sur un substrat électroconducteur et se développent dans une membrane polymère à traces d'ions, **caractérisé en ce que** :

dans une seconde étape, par écoulement/mouvement dans le solvant lors de la dissolution de la membrane polymère à traces d'ions, les différents nanofils isolés ainsi formés constituent par rapprochement/affinité de nanofils du voisinage l'ensemble de structures d'émission de champ faites de faisceaux de nanofils et réparties de manière stochastique,

et qu'au moins dans sa zone exposée, la cathode d'émission de champ est recouverte d'un matériau résistant à la corrosion et présentant un métal précieux.

Fig. 1

Fig. 2

## Fig. 3

Elektrische Feldstärke E [V/μm]

## Fig. 4

## Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **F. Maurer.** *Nucl. Instr. And Meth.in Phys. Research B,* 2006, vol. 245, 337-341
- **von F. Maurer.** *Nucl. Instr. And Meth.*